Europäisches Patentamt

European Patent Office

Office européen des brevets

(19)

(11) **EP 0 632 952 B1**

(12) # EUROPÄISCHE PATENTSCHRIFT

(45) Veröffentlichungstag und Bekanntmachung des Hinweises auf die Patenterteilung:
**22.10.1997 Patentblatt 1997/43**

(21) Anmeldenummer: **93905165.2**

(22) Anmeldetag: **08.03.1993**

(51) Int Cl.6: **H05K 13/08**, H01L 21/00

(86) Internationale Anmeldenummer:
**PCT/DE93/00208**

(87) Internationale Veröffentlichungsnummer:
**WO 93/19577 (30.09.1993 Gazette 1993/24)**

(54) **VERFAHREN ZUR LAGEERKENNUNG UND/ODER TEILUNGSPRÜFUNG UND/ODER KOPLANARITÄTSPRÜFUNG DER ANSCHLÜSSE VON BAUELEMENTEN UND BESTÜCKKOPF FÜR DIE AUTOMATISCHE BESTÜCKUNG VON BAUELEMENTEN**

PROCESS FOR DETERMINING THE POSITION OF COMPONENT LEADS AND FOR CHECKING THEIR SEPARATION AND/OR COPLANARITY, AND PLACING HEAD FOR AUTOMATICALLY PLANTING COMPONENTS

PROCEDE D'IDENTIFICATION DE LA POSITION ET/OU DE CONTROLE DE L'ECARTEMENT ET/OU DE CONTROLE DE LA COPLANARITE DES RACCORDEMENTS DE COMPOSANTS ET TETE POUR L'IMPLANTATION AUTOMATIQUE DE COMPOSANTS

(84) Benannte Vertragsstaaten:
**AT BE CH DE FR GB IT LI NL**

(30) Priorität: **24.03.1992 DE 4209524**

(43) Veröffentlichungstag der Anmeldung:
**11.01.1995 Patentblatt 1995/02**

(73) Patentinhaber: **SIEMENS AKTIENGESELLSCHAFT 80333 München (DE)**

(72) Erfinder: **DOEMENS, Günter D-8150 Holzkirchen (DE)**

(56) Entgegenhaltungen:
**EP-A- 0 320 317**          **GB-A- 2 221 297**

- **IBM TECHNICAL DISCLOSURE BULLETIN Bd. 26, Nr. 7B , 1. Dezember 1983 Seiten 3664 - 3666 DI LORENZO & RIBOULET 'component position recognition method and device for an assembly robot'**

## Beschreibung

Bei der automatischen Bestückung von Leiterplatten oder Keramiksubstraten mit SMD-Bauelementen werden die einzelnen Bauelemente mittels eines Bestückkopfes aus einem Magazin oder einer Zuführeinrichtung entnommen und dann in einer vorgegebenen Lage auf der Leiterplatte oder dem Keramiksubstrat positioniert. Da die Bauelemente im Magazin oder in der Abholposition einer Zuführeinrichtung eine Lagetoleranz von etwa 1 mm aufweiser, auf der Leiterplatte oder dem Keramiksubstrat aber mit hoher Genauigkeit positioniert werden müssen, ist eine automatische Lageerkennung und Korrektur erforderlich. Ferner muß insbesondere bei hochpoligen SMD-Bauelementen die Teilung und die Koplanarität der Anschlüsse überprüft werden. Die Lageerkennung sowie die Teilungs- und Koplanaritätsprüfung sollte dabei möglichst wenig Zeit in Anspruch nehmen, um eine hohe Bestückleistung des Bestückautomaten zu ermöglichen. Zunehmende Bauelementabmessungen von bis zu 70 x 70 mm abnehmende Teilung der Anschlüsse von bis zu 0,3 mm sowie hohe Anforderungen an die Bestückgeschwindigkeit erschweren die Lösung der genannten Aufgaben in erheblichem Umfang.

Bekannte Anordnungen zur Lageerkennung und Teilungsprüfung der Anschlüsse von Bauelementen bilden über ein Objektiv das Bauelement oder Ausschnitte des Bauelements auf eine flächenhafte CCD-Kamera ab und ermitteln über digitale Bildverarbeitung die Lage der Bauelementanschlüsse sowie die Teilung der Anschlüsse. Eine Koplanaritätsprüfung ist bei derartigen Anordnungen nicht möglich.

Bei anderen bekannten Anordnungen zur Lageerkennung und Teilungsprüfung der Anschlüsse von Bauelementen werden die Bauelemente auf eine lichtdurchlässige Platte aufgesetzt, auf der ein Schattenwurf der beleuchteten Anschlüsse erzeugt wird. Die Schattenkanten der Anschlüsse werden dann von unten her über ein Objektiv auf eine flächenhafte CCD-Kamera abgebildet, so daß auch hier wieder die Lage der Bauelementanschlüsse sowie die Teilung der Anschlüsse über digitale Bildverarbeitung ermittelt werden kann. Eine Koplanaritätsprüfung wird bei diesen Anordnungen dadurch ermöglicht, daß die Anschlüsse nacheinander aus zwei unterschiedlichen Richtungen beleuchtet werden (vgl. EP-A-0 425 722 und WO-A-91/15104).

Durch die zunehmende Bauelementgröße, die höheren Genauigkeitsanforderungen sowie die erforderlichen kleinen Erkennungszeiten sind einem Einsatz der bekannten Anordnungen zur Lageerkennung, Teilungsprüfung und ggf. Koplanaritätsprüfung der Anschlüsse von Bauelementen deutliche Grenzen gesetzt, da:

- Bei einer Abmessung der Bauelemente von beispielsweise 70 x 70 mm eine CCD-Kamera mit 4000 x 4000 Bildpunkten notwendig wäre.

- Die Auslesezeit der entsprechenden Information mit ca. 1 s viel zu lange dauert und für eine schnelle Verarbeitung viel zu umfangreich ist.

- Objektive erforderlich sind, die bei einem Gesichtsfeld von 70 x 70 mm eine Verzeichnungsfreiheit von 5 Mikrometern aufweisen. Derartige Objektive sind nur mit einem hohen Kostenaufwand herstellbar und weisen außerdem ein hohes Gewicht und ein großes Bauvolumen auf.

- Aufgrund von Gewicht und Abmessungen der Beleuchtungseinrichtung sowie des Objektivs lassen sich die bekannten Anordnungen zur Lageerkennung und Teilungsprüfung kaum in den Bestückkopf eines Bestückautomaten integrieren, wobei eine derartige Integration ab einer gewissen Größe der Bauelemente mit Sicherheit auszuschließen ist. Die im Hinblick auf die Bestückzeit optimale Lösung mit einer Lageerkennung und Prüfung während des kürzesten Bestückweges zwischen Bauelemententnahme und Bauelementpositionierung ist dann nicht durchführbar.

Aus der DE-A-35 46 316 ist eine Anordnung zur Lageerkennung von Bauelementen bekannt, bei welcher der Bestückkopf einen Bildsensor, wie z. B. eine Fernsehkamera, anfährt und der Bildsensor dann ein Bild des Bauelements an der Saugpipette des Bestückkopfes aufnimmt. Gemäß einer Variante soll es auch möglich sein, den Bildsensor am Bestückkopf anzubringen. Im Hinblick auf das Bauvolumen und das Gewicht des Bildsensors durfte diese Variante aber allenfalls für die Bestückung kleiner Bauelemente realisierbar sein.

Aus der DE-C-33 40 084 ist eine Vorrichtung für die Bestückung von Leiterplatten oder Keramiksubstraten mit Bauelementen bekannt, bei welcher der Bestückkopf eine Lageerfassungs-Einrichtung anfährt, in welcher eine relative Verschiebung des Bauelements gegenüber einer auf die Positionierachse des Bestückkopfes bezogenen Soll-Position ermittelt wird. Die Lageerfassungs-Einrichtung weist einen Rahmen auf, der entlang einer Rahmenseite mit einer Reihe von nebeneinander angeordneten, Strahlen aussendenden Elementen und entlang der gegenüberliegenden Rahmenseite mit einer Reihe von nebeneinander angerodneten, die genannten Strahlen empfangenden Elementen bestückt ist. Wird nun ein an der Saugpipette des Bestückkopfes gehaltenes Bauelement in den Rahmen transportiert, so liegen die mittig angeordneten Empfangselemente im Schatten des Bauelements. Das Verhältnis der linksseitigen und der rechtsseitigen Empfangselemente, die einen Strahl empfangen, bildet ein Maß für die Exzentrizität des Bauelements in der ensprechenden Richtung.

Desweiteren oftenbart IBM TECHNICAL DISCLOSURE BULLETIN Bd. 26, Nr. 7B, 1. Dezember 1983, Seiten 3664 - 3666 DI LORENZO & RIBOULET 'component position recognition method and device for an assembly robot' eine Anordnung zur lageerkennung von Bauteilen, bei welcher zur Bildverarbeitung CCD-Kameras benutzt werden.

Der Erfindung liegt das Problem zugrunde, den für die Lageerkennung und/oder Teilungsprüfung und/oder Koplanaritätsprüfung der Anschlüsse von Bauelementen erforderlichen baulichen Aufwand zu reduzieren und eine schnelle Verarbeitung zu ermöglichen.

Die in den Ansprüchen 1,2 und 14 angegebenen Lösungen dieses Problems beruhen auf dem gemeinsamen Gedanken, auf der lichtempfindlichen Fläche eines ortsauflösenden optoelekktronischen Wandlers einen unmittelbaren Schattenwurf des Anschlußbereichs einer Bauelementseite zu erzeugen. Durch diesen unmittelbaren Schattenwurf kann auf eine abbildende Optik vollständig verzichtet werden.

Gemäß der im Anspruch 1 angegebenen Lösung wird durch Beleuchtung aus zwei unterschiedlichen Richtungen auf der lichtempfindlichen Fläche des ortsauflösenden optoelektronischen Wandlers nacheinander je ein unmittelbarer Schattenwurf des Anschlußbereichs einer Bauelementseite erzeugt. Neben der Lageerkennung und Teilungsprüfung wird hierdurch zusätzlich auch noch eine Koplanaritätsprüfung der Anschlüsse ermöglicht. Das Verfahren kann für die Teilungsprüfung und Koplanaritätsprüfung in der Qualitätskontrolle oder für die Lageerkennung, Teilungsprüfung und Koplanaritätsprüfung bei der automatischen Bestückung von Bauelementen eingesetzt werden.

Gemäß der in Anspruch 2 angegebenen, speziell für die SMD-Bestückung geeigneten Lösung wird wieder durch Beleuchtung aus zwei unterschiedlichen Richtungen auf der lichtempfindlichen Fläche des ortsauflösenden optoelektronischen Wandlers nacheinander je ein unmittelbarer Schattenwurf des Anschlußbereichs einer Bauelementseite erzeugt, wobei hier jedoch der ortsauflösende optoelektronische Wandler am Bestückkopf befestigt wird. Die Beleuchtung aus zwei unterschiedlichen Richtungen kann durch eine vom Bestückkopf anzufahrende Einrichtung oder durch eine am Bestückkopf angebrachte Einrichtung vorgenommen werden.

Gemäß der im Anspruch 14 angegebenen Lösung ist ein Bestückkopf für die automatische Bestückung von Leiterplatten oder Keramiksubstraten mit Bauelementen mit einer Saugpipette, einem ortsauflösenden optoelektronischen Wandler und mindestens einer Lichtquelle ausgerüstet, wobei mit der Lichtquelle auf der lichtempfindlichen Fläche des ortsauflösenden optoelektronischen Wandlers aus zwei unterschiedlichen Richtungen nacheinander je ein unmittelbarer Schattenwurf des Anschlußbereichs einer Bauelementseite erzeugt wird. Durch die geschilderten baulichen Maßnahmen wird eine Lageerkennung, Teilungs- und Koplanaritätsprüfung der Anschlüsse der von der Saugpipette aufgenommenen Bauelemente ermöglicht, wobei diese Vorgänge während des Weges von der Bauelemente-Bereitstellungseinrichtung zur Bestückposition im Bestückkopf ablaufen können und somit keine zusätzliche Zeit benötigen. Vorteilhafte Ausgestaltungen der erfindungsgemäßen Verfahren sind in den Ansprüchen 3-13 angegeben. Vorteilhafte Ausgestaltungen des erfindungsgemäßen Bestückkopfes sind in den Ansprüchen 15-20 angegeben.

Gemäß Anspruch 5 kann der ortsauflösende optoelektronische Wandler bereits durch eine einzige Fotodiode gebildet werden, sofern diese in zwei zueinander senkrechten Richtungen verfahren wird.

Die Weiterbildung nach Anspruch 4 betrifft eine besonders bevorzugte Bildung des ortsauflösenden optoelektronischen Wandlers durch eine senkrecht zur Zeilenrichtung verfahrbare Fotodiodenzeile. Da Fotodiodenzeilen auch in der für besonders große Bauelemente erforderlichen Länge im Handel erhältlich sind, ist diese Lösung mit einem besonders geringen Aufwand realisierbar. Gemäß Anspruch 5 ist es dabei zweckmäßig, eine Fotodiodenzeile zu verwenden, deren einzelne Fotodioden senkrecht zur Zeilenrichtung langgestreckte, rechteckförmige lichtempfindliche Flächen aufweisen. Derartige Fotodiodenzeilen sind gegen eine Einwirkung von Staub besonders unempfindlich.

Gemäß Anspruch 6 kann als ortsauflösender optoelektronischer Wandler auch eine Fotodiodenmatrix verwendet werden, d. h. auf eine Bewegung einzelner Fotodioden oder einer Fotodiodenzeile kann in diesem Fall verzichtet werden.

Die Ausgestaltung nach Anspruch 7 ermöglicht eine Lageerkennung, Teilungsprüfung und Koplanaritätsprüfung der Anschlüsse von Bauelementen durch Zentralprojektion aus zwei unterschiedlichen Richtungen. Dabei erfordert es gemäß Anspruch 8 einen besonders geringen Aufwand, wenn zur Zentralprojektion aus zwei unterschiedlichen Richtungen zwei im Abstand zueinander angeordnete punktförmige Lichtquellen verwendet werden.

Die Ausgestaltung nach Anspruch 9 betrifft die Verwendung einer Laserdiode als punktförmige Lichtquelle. Derartige Laserdioden sind kostengünstig und zeichnen sich außerdem durch ein geringes Gewicht und durch eine gute Punktförmigkeit aus.

Wird die punktförmige Lichtquelle gemäß Anspruch 10 am Bestückkopf angebracht, so können Lageerkennung, Teilungsprüfung und Koplanaritätsprüfung der Anschlüsse der Bauelemente ohne Zeitverlust auf dem kürzesten Bestückweg zwischen Bauelemententnahme und Bauelementpositionierung durchgeführt werden. Gemäß Anspruch 11 ist es dann besonders günstig, wenn die punktförmige Lichtquelle synchron mit der Fotodiodenzeile senkrecht zu deren Zeilenrichtung verfahren wird. Durch diese Maßnahme wird mit geringem Aufwand ein exakter Schattenwurf des gesamten Anschlußbereichs einer Bauelementseite gewährleistet.

Die Ausgestaltung nach Anspruch 12 ermöglicht durch eine einfache Drehung des jeweiligen Bauelements in Schritten von 90° und 180° eine Erfassung aller Anschlußbereiche. Diese Drehung kann dann gemäß Anspruch 13 ohne zusätzlichen Aufwand mit Hilfe der Saugpipette eines Bestückkopfes vorgenommen werden.

Die Ausgestaltung gemäß Anspruch 15 betrifft die Anbringung einer senkrecht zu ihrer Zeilenrichtung verfahrbaren Fotodiodenzeile am Bestückkopf. Wie bereits erwähnt wurde, sind Fotodiodenzeilen auch in der für besonders große Bauelemente erforderlichen Länge im Handel erhältlich, so daß die Realisierung des ortsauflösenden optoelektronischen Wandlers in diesem Fall einen besonders geringen Aufwand erfordert. Gemäß Anspruch 16 wird dann auch hier wieder eine gegen die Einwirkung von Staub besonders robuste Ausführung erreicht, wenn die einzelnen Fotodioden der Fotodiodenzeile eine senkrecht zur Zeilenrichtung langgestreckte rechteckförmige lichtempfindliche Fläche aufweisen.

Gemäß den Ansprüchen 17 und 18 ist es besonders günstig, am Bestückkopf eine punktförmige Lichtquelle, vorzugsweise zwei im Abstand zueinander angeordnete punktförmige Lichtquellen anzubringen. Dabei sind auch hier wieder gemäß Anspruch 19 zwei im Abstand zueinander angeordnete Laserdioden im Hinblick auf den geringen kostenmäßigen Aufwand, das geringe Gewicht und die gute Punktförmigkeit anderen punktförmigen Lichtquellen vorzuziehen.

Die Ausgestaltung nach Anspruch 20 ermöglicht eine besonders einfache synchrone Verstellung der punktförmigen Lichtquellen und der Fotodiodenzeile.

Ausführungsbeispiele der Erfindung sind in der Zeichnung dargestellt und werden im folgenden näher beschrieben.

Es zeigen:

Figur 1 das Grundprinzip zur Lageerkennung und Teilungsprüfung der Anschlüsse von Bauelementen, bei welchem durch Beleuchtung mit parallelem Licht auf der lichtempfindlichen Fläche eines ortsauflösenden optoelektronischen Wandlers ein unmittelbarer Schattenwurf des Anschlußbereichs einer Bauelementseite erzeugt wird,

Figur 2 das Grundprinzip einer ersten Ausführungsform zur Lageerkennung, Teilungsprüfung und Koplanaritätsprüfung der Anschlüsse von Bauelementen, bei welchem durch Beleuchtung mit parallelem Licht aus zwei unterschiedlichen Richtungen auf der lichtempfindlichen Fläche eines ortsauflösenden optoelektronischen Wandlers nacheinander je ein unmittelbarer Schattenwurf des Anschlußbereichs einer Bauelementseite erzeugt wird,

Figur 3 das Grundprinzip einer Ausführungsform zur Lageerkennung, Teilungsprüfung und Koplanaritätsprüfung der Anschlüsse von Bauelementen, bei welcher durch Zentralprojektion aus zwei unterschiedlichen Richtungen auf der lichtempfindlichen Fläche eines ortsauflösenden optoelektronischen Wandlers nacheinander je ein Schattenwurf des Anschlußbereichs einer Bauelementseite erzeugt wird,

Figur 4 eine Variante der in Figur 3 dargestellten Ausführungsform, bei welcher als ortsauflösender optoelektronischer Wandler eine senkrecht zur Zeilenrichtung verfahrbare Fotodiodenzeile verwendet wird,

Figur 5 und Figur 6 die Anordnung von Fotodiodenzeile und punktförmigen Lichtquellen entsprechend der in Figur 4 dargestellten Variante beim Prüfvorgang und beim Bestückvorgang und die

Figuren 7 und 8 die Ermittlung der räumlichen Lage der Anschlüsse eines Bauelements entsprechend der in Figur 4 dargestellten Variante.

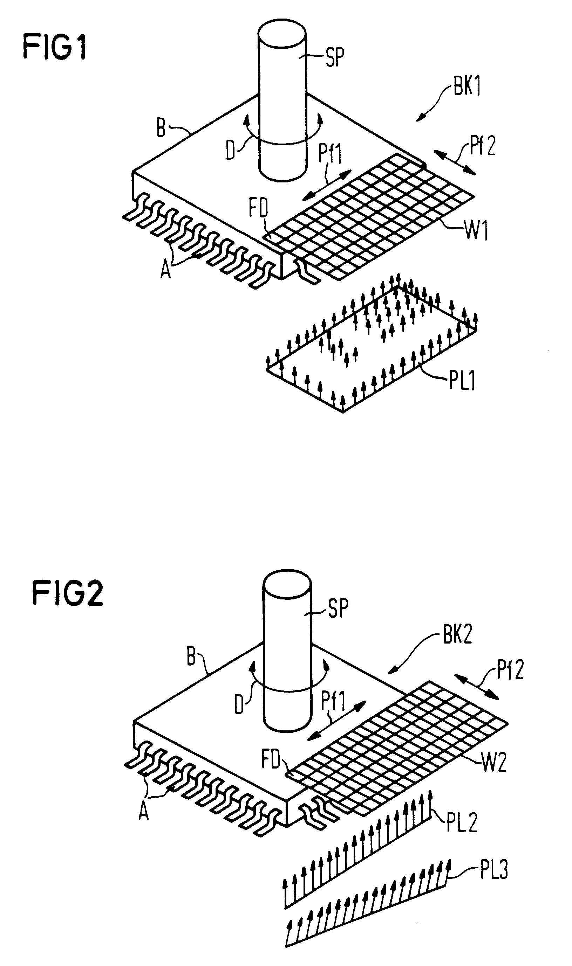

Figur 1 zeigt in stark vereinfachter schematische Darstellung einen Bestückkopf BK1, dessen Saugpipette SP ein Bauelement B trägt. Bei dem dargestellten Bauelement B handelt es sich um ein Quad-Flat-Pack, das auf jeder Bauelementseite zehn Anschlüsse A besitzt. Am Bestückkopf BK1 ist ein ortsauflösender optoelektronischer Wandler W1 derart befestigt, daß durch Beleuchtung mit parallelem Licht PL1 auf seiner lichtempfindlichen Fläche ein unmittelbarer Schattenwurf des Anschlußbereichs einer Bauelementseite erzeugt wird. Aus der Lage der Schattenkanten der Anschlüsse A auf dem ortsauflösenden optoelektronischen Wandler W1 kann dann die Lage der Anschlüsse A beispielsweise in bezug auf die Symmetrieachse der Saugpipette SP ermittelt und auch die Teilung der Anschlüsse A überprüft werden. Durch Drehung des Bauelements B relativ zu dem ortsauflösenden optoelektronischen Wandler W1 in Schritten von 90° können die Anschlußbereiche der übrigen drei Bauelementseiten zur Lageerkennung und Teilungsprüfung erfaßt werden. Diese durch einen Doppelpfeil D angedeutete Drehung des Bauelements B wird durch eine entsprechende Drehung der Saugpipette SP vorgenommen.

Die lichtempfindliche Fläche des in Figur 1 dargestellten ortsauflösenden optoelektronischen Wandlers W1 erstreckt sich in Richtung des Doppelpfeils Pf1 parallel zu der betreffenden Bauelementkante über den Bereich der Anschlüsse A und senkrecht dazu in Richtung des Doppelpfeils Pf2. Die Erstreckung der lichtempfindlichen Fläche in Richtung des Doppelpfeils Pf2 ist im Hinblick auf etwaige Verdrehungen des Bauelements B erforderlich da derartige Verdrehungen eine exakte parallele Ausrichtung von Bauelementkante und Wandler W1 verhindern.

Die lichtempfindliche Fläche des ortsauflösenden optoelektronischen Wandlers W1 kann durch eine einzige Fotodiode FD erzeugt werden, die in Richtung der Doppelpfeile Pf1 und Pf2 entsprechend verfahren wird.

Die lichtempfindliche Fläche des ortsauflösenden optoelektronischen Wandlers W1 kann aber auch durch eine sich in Richtung des Doppelpfeiles Pf1 erstrekkende Fotodiodenzeile erzeugt werden, die in Richtung des Doppelpfeils Pf2 verfahren wird. Weiterhin kann die licht-empfindliche Fläche des ortsauflösenden optoelektroni-schen Wandlers W1 durch eine Fotodiodenmatrix gebildet sein, deren Zeilen und Spalten sich in Richtung der Doppelpfeile Pf1 und Pf2 erstrecken.

Das parallele Licht PL1 zur Erzeugung eines unmittelbaren Schattenwurfs des Anschlußbereichs einer Bauelementseite auf der lichtempfindlichen Fläche des ortsauflösenden optoelektronischen Wandlers W1 ist in Figur 1 durch eine Vielzahl von Pfeilen angedeutet, die matrixförmig entsprechend den Richtungen Pf1 und Pf2 ausgerichtet sind. Die Erzeugung des parallelen Lichts PL1 kann auch hier durch Bewegung einer einzigen Lichtquelle in Richtung der Doppelpfeile Pf1 und Pf2 oder durch Bewegung einer sich in Richtung des Doppelpfeils Pf1 erstreckenden zeilenförmigen Anordnung von Lichtquellen in Richtung des Doppelpfeils Pf2 realisiert werden. Die Einrichtung, welche das parallele Licht PL1 erzeugt, kann entweder vom Bestückkopf BK1 angefahren werden oder direkt am Bestückkopf BK1 befestigt werden.

Figur 2 zeigt in stark vereinfachter schematischer Darstellung einen Bestückkopf BK2, dessen Saugpipette SP ein Bauelement B trägt. Am Bestückkopf BK2 ist ein ortsauflösender optoelektronischer Wandler W2 derart befestigt daß durch Beleuchtung mit parallelem Licht PL2 und PL3 aus zwei unterschiedlichen Richtungen auf seiner lichtempfindlichen Fläche nacheinander je ein unmittelbarer Schattenwurf des Anschluß-reichs einer Bauelementseite erzeugt wird. Aus der un-terschiedlichen Lage korrespondierender Schattenkan-ten der Anschlüsse A auf der lichtempfindlichen Fläche des ortsauflösenden optoelektronischen Wandlers W2 kann dann die räumliche Lage der Anschlüsse A berechnet werden. Die Berechnung der räumlichen Lage der Anschlüsse A umfaßt eine Lageerkennung sowie eine Teilungs- und Koplanaritätsprüfung.

Durch Drehung D des Bauelements B relativ zu dem ortsauflösenden optoelektronischen Wandler W2 in Schritten von 90° können die Anschlußbereiche der übrigen drei Bauelementseiten zur Lageerkennung sowie Teilungs- und Koplanaritätsprüfung erfaßt werden. Diese Drehung D des Bauelements B wird auch hier wieder mit Hilfe der Saugpipette SP vorgenommen.

Bezüglich des Aufbaus und der Wirkungsweise des auflösenden optoelektronischen Wandlers W2 wird auf die Ausführungen zu dem ortsauflösenden optoelektronischen Wandler W1 des in Figur 1 dargestellten Bestückkopfes BK1 verwiesen.

Das parallele Licht PL2 und PL3 ist in Figur 2 durch zwei Scharen von Pfeilen unterschiedlicher Richtung angedeutet. Die Erzeugung des parallelen Lichts PL2 und PL3 kann beispielsweise durch eine zeilenförmige Anordnung entsprechender Lichtquellen vorgenommen werden, die gegebenenfalls in Richtung des Doppelpfeils Pf2 bewegt werden. Die entsprechenden Lichtquellen können entweder vom Bestückkopf BK2 angefahren werden oder direkt am Bestückkopf BK2 befestigt werden.

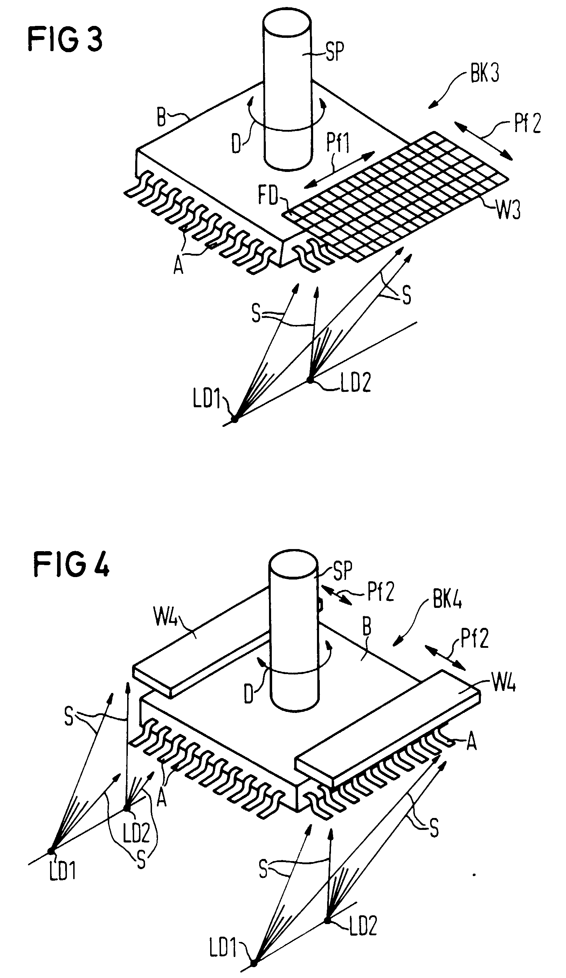

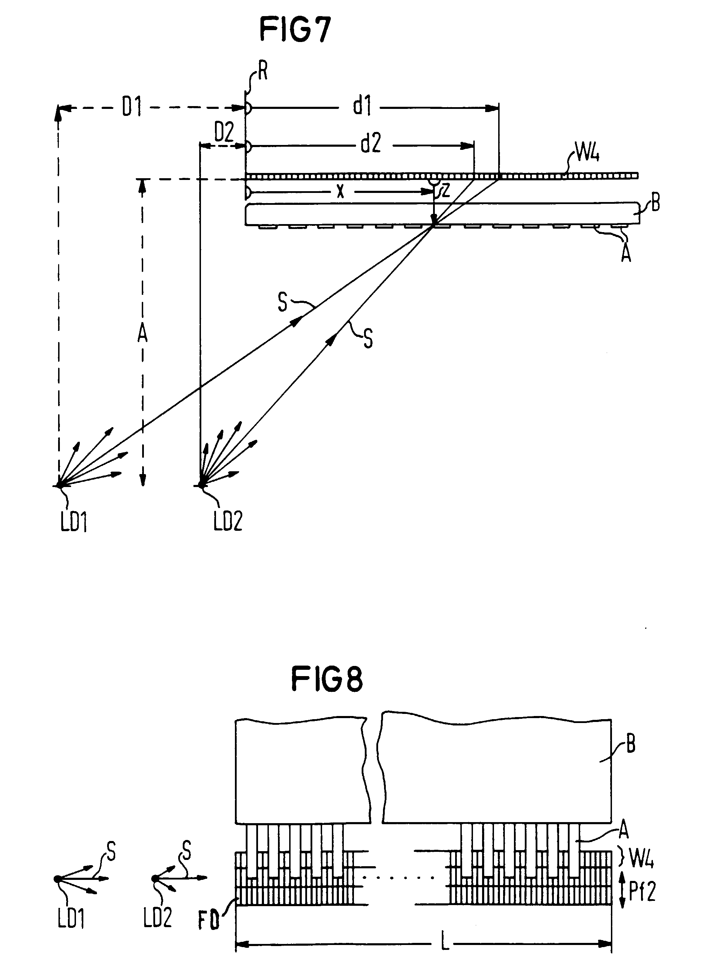

Figur 3 zeigt in stark vereinfachter schematischer Darstellung einen Bestückkopf BK3, dessen Saugpipette SP ein Bauelement B trägt. Am Bestückkopf BK3 ist ein ortsauflösender optoelektronischer Wandler W3 derart befestigt, daß durch Zentralprojektion aus zwei unterschiedlichen Richtungen auf seiner lichtempfindlichen Fläche nacheinander je ein unmittelbarer Schattenwurf des Anschlußbereichs einer Bauelementseite erzeugt wird. Aus der unterschiedlichen Lage korrespondierender Schattenkanten der Anschlüsse A auf der lichtempfindlichen Fläche des ortsauflösenden optoelektronischen Wandlers W3 kann dann durch Anwendung der geometrischen Strahlengesetze die räumliche Lage der Anschlüsse A berechnet werden. Diese Berechnung wird an späterer Stelle anhand der Figuren 7 und 8 im Detail erläutert. Die Berechnung der räumlichen Lage der Anschlüsse A umfaßt dann auch hier wieder eine Lageerkennung sowie eine Teilungs- und Koplanaritätsprüfung.

Durch Drehung D des Bauelements B relativ zu dem ortsauflösenden optoelektronischen Wandler W3 in Schritten von 90° können die Anschlußbereiche der übrigen drei Bauelementseiten zur Lageerkennung sowie Teilungs- und Koplanaritätsprüfung erfaßt werden. Diese Drehung D des Bauelements B wird auch hier wieder mit Hilfe der Saugpipette SP vorgenommen.

Bezüglich des Aufbaus und der Wirkungsweise des ortsauflösenden optoelektronischen Wandlers W3 wird auf die entsprechenden Ausführungen zu dem ortsauflösenden optoelektronischen Wandler W1 des in Figur 1 dargestellten Bestückkopfes B1 verwiesen.

Die vorstehend erwähnte Zentralprojektion aus zwei unterschiedlichen Richtungen wird durch zwei im Abstand zueinander angeordnete Laserdioden LD1 und LD2 bewirkt. Diese am Bestückkopf BK3 angebrachten Laserdioden LD1 un LD2 sollen - wie es durch Pfeile S angedeutet ist - nacheinander je einen unmittelbaren Schattenwurf des Anschlußbereichs einer Bauelementseite auf der lichtempfindlichen Fläche des ortsauflösenden optoelektronischen Wandlers W3 erzeugen. Da es sich bei den Laserdioden LD1 und LD2 um punktförmige Lichtquellen handelt, liegt hier jeweils ein Schattenwurf durch Zentralprojektion vor.

Figur 4 zeigt eine Variante des in Figur 3 dargestellten Bestückkopfes. Der hier mit BK4 bezeichnete Bestückkopf trägt auf einander gegenüberliegenden Seiten jeweils einen ortsauflösenden optoelektronischen Wandler W4. Die beiden ortsauflösenden optoelektronischen Wandler W4 sind jeweils durch eine senkrecht zu ihrer Zeilenrichtung, d. h. in Richtung der Doppelpfeile Pf2, verfahrbare Fotodiodenzeile gebildet. Den beiden Fotodiodenzeilen sind jeweils zwei im Abstand zueinander angeordnete Laserdioden LD1 und LD2 zugeordnet.

Bei dem in Figur 4 dargestellten Ausführungsbeispiel können durch eine einmalige Drehung D des Bauelements B relativ zu den beiden ortsauflösenden optoelektronischen Wandlern W4 um 90° auch die übrigen beiden Bauelementseiten zur Lageerkennung sowie Teilungs- und Koplanaritätsprüfung der Anschlüsse erfaßt werden.

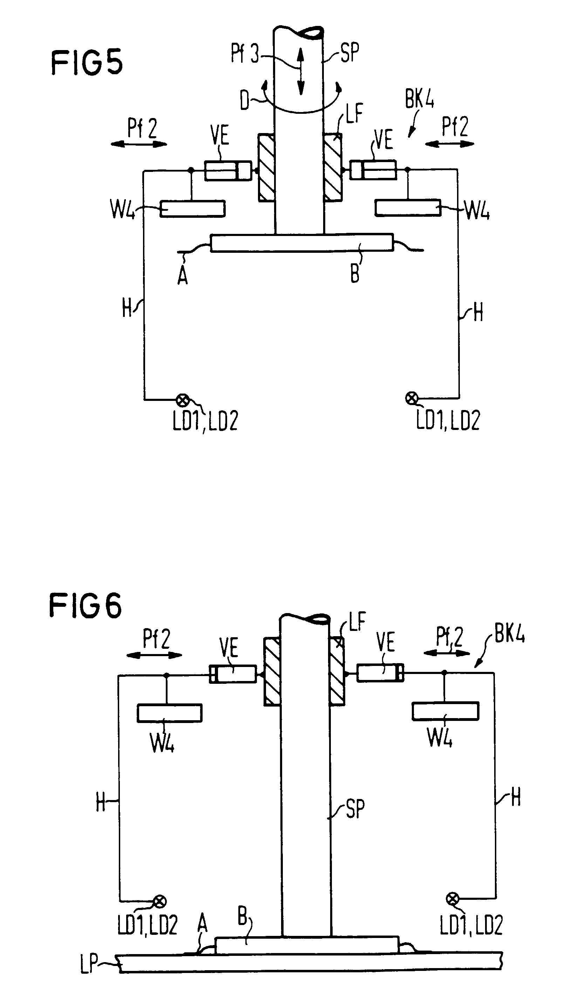

Die Figuren 5 und 6 zeigen in stark vereinfachter schematischer Darstellung für den in Figur 4 dargestellten Bestückkopf BK4 die Anordnung von Fotodiodenzeilen und Lichtquellen beim Prüfvorgang und beim Bestückvorgang. Es ist zu erkennen, daß die ortsauflösenden optoelektronischen Wandler W4 und die beiden zugeordneten, senkrecht zur Zeichnungsebene hintereinander liegenden, Laserdioden LD1 und LD2 jeweils an einer gemeinsamen Halterung H befestigt sind. Die einander gegenüberliegenden Halterungen H sind mit Hilfe von Verstelleinrichtungen VE in Richtung der Doppelpfeile Pf2 verfahrbar, d. h. beim Prüfvorgang werden die ortsauflösenden optoelektronischen Wandler W4 synchron mit den zugeordneten Laserdioden LD1 und LD2 relativ zu den zu erfassenden Anschlüssen A verfahren. Die Verstelleinrichtungen VE sind an einer Längsführung LF angebracht, in welcher die Saugpipette SP in Richtung des Doppelpfeiles Pf3 heb- und senkbar und in Richtung des Doppelpfeiles D drehbar gelagert ist. Nach dem in Figur 5 dargestellten Lageerkennungs- und Prüfvorgang werden die beiden Halterungen H gemäß Figur 6 radial nach außen verfahren, so daß das Bauelement B unbehindert durch Absenken der Saugpipette SP auf der vorgegebenen Bestückposition einer Leiterplatte LP abgelegt werden kann. Bei dieser Positionierung des Bauelements B auf der Leiterplatte LP wird das Ergebnis der zuvor durchgeführten Lageerkennung gegebenenfalls durch eine entsprechende Korrektur berücksichtigt. Diese Korrektur kann sowohl eine Verschiebung als auch eine Verdrehung des Bauelements B relativ zur Leiterplatte LP beinhalten.

Die Figuren 7 und 8 zeigen für den vorstehend anhand der Figuren 4, 5 und 6 beschriebenen Bestückkopf BK4 die Ermittlung der räumlichen Lage der Anschlüsse A eines Bauelements B. Figur 7 zeigt den durch eine Fotodiodenzeile gebildeten ortsauflösenden optoelektronischen Wandler W4, das unmittelbar darunter angeordnete Bauelement B mit den Anschlüssen A und unterhalb davon die beiden im Abstand voneinander angeordneten Laserdioden LD1 und LD2. Die in Figur 8 mit L bezeichnete Länge der Fotodiodenzeile ist dabei auf die Länge des Bauelements B abgestimmt.

In vertikaler Richtung ist der Abstand zwischen der Unterseite der Fotodiodenzeile und den beiden Laserdioden LD1 und LD2 mit A' bezeichnet. In horizontaler Richtung ist der Abstand zwischen den Laserdioden LD1 und LD2 und dem in Figur 7 linken Rand R der Fotodiodenzeile D1 bzw. D2 bezeichnet. Die durch die Strahlung S der Laserdioden LD1 und LD2 auf der Fotodiodenzeile nacheinander erzeugten Schattenkanten eines bestimmten Anschlusses A weisen vom linken Rand R der Fotodiodenzeile in horizontaler Richtung einen Abstand d1 bzw. einen Abstand d2 auf. Der horizontale Abstand dieses bestimmten Anschlusses A vom linken Rand R ist durch die Koordinate x aufgezeigt, während in vertikaler Richtung der Abstand der Anschlüsse A von der Unterseite der Fotodiodenzeile durch die Koordinate z aufgezeigt ist. Durch die Ermittlung der Koordinaten x kann eine Lageerkennung und eine Teilungsprüfung der Anschlüsse A durchgeführt werden, während die Koordinaten z der Anschlüsse A eine Koplanaritätsprüfung ermöglichen.

Mit Hilfe der vorgegebenen Maße A', D1 und D2 und der von der Fotodiodenzeile registrierten Maße d1 und d2 lassen sich für die Lageerkennung, Teilungs- und Koplanaritätsprüfung die Koordinaten x und z mit Hilfe der Beziehungen

$$x = \frac{d1 \cdot D2 - d2 \cdot D1}{(D2-D1) + (d2-d1)}$$

und

$$z = \frac{A'(d2-x)}{D2 + d2}$$

berechnen.

Aus Figur 8 ist auch ersichtlich, daß der durch eine Fotodiodenzeile gebildete Wandler W4 rechteckförmige Fotodioden FD aufweist und in Richtung des Doppelpfeile Pf2 verfahrbar ist. Durch diese Verfahrbarkeit ist ein eindeutiger Schattenwurf der Anschlüsse A auch bei einer Verdrehung des Bauelements B gewährleistet. Außerdem ermöglicht das Verfahren der Fotodiodenzeile auch die Ermittlung der Verdrehung eines Bauelements B, so daß auch etwaige Verdrehungen bei der Positionierung auf einer Leiterplatte korrigiert werden können.

Bei dem vorstehend anhand der Figuren 4 bis 8 beschriebenen bevorzugten Ausführungsbeispiel werden als ortsauflösende optoelektronische Wandler W Fotodiodenzeilen der Firma Reticon, Sunnyvale, Kalifornien, USA mit der Bezeichnung RL 4096 N verwendet. Diese Fotodiodenzeilen umfassen jeweils 4096 in einer Reihe angeordnete einzelne Fotodioden, wobei die lichtempfindlichen Flächen der einzelnen Fotodioden Abmessungen von 15 x 16 Mikrometern aufweisen. Die Länge einer Fotodiodenzeile beträgt 60 mm. Als punktförmige Lichtquellen bzw. Laserdioden LD1 und LD2 werden Laserdioden der Firma Hitachi Ltd, Tokio, Japan mit der Bezeichnung HL 6711 C eingesetzt. Diese Laserdioden weisen eine Leistung von 5 mW auf und emittieren Licht mit einer Wellenlänge von 670 nm. Durch die hohe Anzahl der einzelnen Fotodioden einer Fotodiodenzeile wird gewährleistet, daß bei hoher Auflösung nur die notwendige Information aufgenommen wird und in kürzester Zeit von beispielsweise 2 ms ausgelesen werden kann.

Abweichend von den beschriebenen Ausführungsbeispielen kann es bei bestimmten Bestückköpfen auch zweckmäßig sein, die Anordnung von Fotodiodenzeilen und Laserdioden zu vertauschen. In diesem Fall werden die Laserdioden oberhalb des Bauelements und die Fotodiodenzeilen unterhalb des Bauelements am Bestückkopf angebracht.

**Patentansprüche**

1. Verfahren zur Lageerkennung und/oder Teilungsprüfung und/oder Koplanaritätsprüfung der Anschlüsse (A) von Bauelementen (B), bei welchem durch Beleuchtung aus zwei unterschiedlichen Richtungen auf der lichtempfindlichen Fläche eines ortsauflösenden optoelektronischen Wandlers (W2; W3; W4) nacheinander je ein unmittelbarer Schattenwurf des Anschlußbereichs einer Bauelementseite erzeugt wird und aus der unterschiedlichen Lage korrespondierender Schattenkanten der Anschlüsse (A) auf dem optoelektronischen Wandler (W2; W3; W4) die räumliche Lage der Anschlüsse (A) berechnet wird.

2. Verfahren zur Lageerkennung und/oder Teilungsprüfung und/oder Koplanaritätsprüfung der Anschlüsse (A) von Bauelementen (B), die mit Hilfe eines Bestückkopfes (BK2; BK3; BK4) aus einer vorgegebenen Entnahmeposition einer Bauelemente-Bereitstellungseinrichtung entnommen und in einer vorgegebenen Lage auf einer Leiterplatte (LP) oder einem Keramiksubstrat positioniert werden,
    **dadurch gekennzeichnet,**
    daß durch Beleuchtung aus zwei unterschiedlichen Richtungen auf der lichtempfindlichen Fläche eines am Bestückkopf (BK2; BK3; BK4) angebrachten ortsauflösenden optoelektronischen Wandlers (W2; W3; W4) nacheinander je ein unmittelbarer Schattenwurf des Anschlußbereichs einer Bauelementseite erzeugt wird und daß aus der unterschiedlichen Lage korrespondierender Schattenkanten der Anschlüsse (A) auf dem optoelektronischen Wandler (W2; W3; W4) die räumliche Lage der Anschlüsse (A) berechnet wird.

3. Verfahren nach einem der Ansprüche 1 oder 2,
    **dadurch gekennzeichnet,**
    daß als ortsauflösender optoelektronischer Wandler (W1; W2; W3) eine in zwei zueinander senkrechten Richtungen (Pf1, Pf2) verfahrbare Fotodiode (FD) verwendet wird.

4. Verfahren nach einem der Ansprüche 1 bis 2,
    **dadurch gekennzeichnet**,
    daß als ortsauflösender optoelektronischer Wandler (W4) eine senkrecht zur Zeilenrichtung verfahrbare Fotodiodenzeile verwendet wird.

5. Verfahren nach Anspruch 4,
    **dadurch gekennzeichnet,**
    daß eine Fotodiodenzeile verwendet wird, deren einzelne Fotodioden (FD) senkrecht zur Zeilenrichtung langgestreckte, rechteckförmige lichtempfindliche Flächen aufweisen.

6. Verfahren nach einem der Ansprüche 1 bis 2,
    **dadurch gekennzeichnet,**
    daß als ortsauflösender optoelektronischer Wandler (W1; W2; W3) eine Fotodiodenmatrix verwendet wird.

7. Verfahren nach einem der Ansprüche 1 bis 6,
    **dadurch gekennzeichnet,**
    daß zur Beleuchtung in zwei unterschiedlichen Richtungen mindestens eine punktförmige Lichtquelle verwendet wird.

8. Verfahren nach Anspruch 7,
    **dadurch gekennzeichnet,**
    daß zur Beleuchtung in zwei unterschiedlichen Richtungen zwei im Abstand zueinander angeordnete punktförmige Lichtquellen verwendet werden.

9. Verfahren nach Anspruch 7 oder 8,
    **gekennzeichnet durch**
    die Verwendung einer Laserdiode (LD1, LD2) als punktförmige Lichtquelle.

10. Verfahren nach Anspruch 2 und einem der Ansprüche 7 bis 9,
    **dadurch gekennzeichnet,**
    daß zur Beleuchtung in zwei unterschiedlichen Richtungen mindestens eine am Bestückkopf (BK3; BK43) angebrachte punktförmige Lichtquelle verwendet wird.

11. Verfahren nach den Ansprüchen 4 und 10,
    **dadurch gekennzeichnet,**
    daß die punktförmige Lichtquelle synchron mit der Fotodiodenzeile senkrecht zu deren Zeilenrichtung verfahren wird.

12. Verfahren nach einem der vorhergehenden Ansprüche,
    **dadurch gekennzeichnet,**
    daß das jeweilige Bauelement (B) zur Erfassung aller Anschlußbereiche relativ zu dem ortsauflösenden optoelektronischen Wandler (W1; W2; W3; W4) in Schritten von 90° oder 180° gedreht wird.

13. Verfahren nach Anspruch 2 und nach Anspruch 12,
    **dadurch gekennzeichnet,**

daß die Bauelemente (B) mit Hilfe der Saugpipette (SP) des Bestückkopfes (BK1; BK2; BK3; BK4) gedreht werden.

14. Bestückkopf (BK4) für die automatische Bestük-kung von Leiterplatten (LP) oder Keramiksubstraten mit Bauelementen (B), mit

- einer Saugpipette (SP) zum Aufnehmen, Transportieren und Positionieren der Bauelemente,
- einem ortsauflösenden optoelektronischen Wandler (W4) und mit
- mindestens einer Lichtquelle, wobei
- die Saugpipette (SP), der ortsauflösende optoelektronische Wandler (W4) und die Lichtquelle derart angeordnet sind, daß die Lichtquelle durch Beleuchtung aus zwei unterschiedlichen Richtungen auf der lichtempfindlichen Fläche des ortsauflösenden optoelektronischen Wandlers (W4) nacheinander je ein unmittelbarer Schattenwurf des Anschlußbereichs einer Bauelementseite eines von der Saugpipette (SP) aufgenommenen Bauelements(B) erzeugt und aus der unterschiedlichen Lage kor-respondierender Schattenkanten der An-schlüsse (A) des Bauelements (B) auf dem optoelektronischen Wandler (W4) die räumliche Lage der Anschlüsse (A) berechnet wird.

15. Bestückkopf nach Anspruch 14,
   **dadurch gekennzeichnet,**
   daß der ortsauflösende optoelektronische Wandler (W4) durch eine senkrecht zu ihrer Zeilenrichtung verfahrbare Fotodiodenzeile gebildet ist.

16. Bestückkopf nach Anspruch 15,
   **dadurch gekennzeichnet**
   daß die einzelnen Fotodioden (FD) der Foto-diodenzeile senkrecht zur Zeilenrichtung langge-streckte, rechteckförmige lichtempfindliche Flä-chen aufweisen.

17. Bestückkopf nach einem der Ansprüche 14 bis 16,
   **gekennzeichnet durch**
   eine punktförmige Lichtquelle.

18. Bestückkopf nach Anspruch 17,
   **gekennzeichnet durch**
   zwei im Abstand zueinander angeordnete punktförmige Lichtquellen.

19. Bestückkopf nach Anspruch 18,
   **gekennzeichnet durch**
   zwei im Abstand zueinander angeordnete Laserdioden (LD1, LD2).

20. Bestückkopf nach den Ansprüchen 15 und 18 oder 19,
   **dadurch gekennzeichnet,**
   daß die punktförmigen Lichtquellen über eine gemeinsame Halterung (H) synchron mit der Fotodiodenzeile senkrecht zu deren Zeilenrichtung verfahrbar sind.

**Claims**

1. Process for determining the position and/or checking the separation and/or checking the coplanarity of the leads (A) of components (B), in which process in each case one direct shadow of the region of the leads at one side of the component is generated successively by illumination from two different directions on the photosensitive surface of a spatially resolving optoelectronic transducer (W2; W3; W4) and the spatial position of the leads (A) is computed from the differing position of corresponding shadow edges of the leads (A) on the optoelectronic transducer (W2; W3; W4).

2. Process for determining the position and/or checking the separation and/or checking the coplanarity of the leads (A) of components (B), which are removed from a predetermined removal position of a component preparation device by means of a planting head (BK2; BK3; BK4) and are positioned in a predetermined position on a printed circuit board (LP) or a ceramic substrate, characterized in that in each case one direct shadow of the region of the leads at one side of the component is generated successively by illumination from two different directions on the photosensitive surface of a spatially resolving optoelectronic transducer (W2; W3; W4) fitted to the planting head (BK2; BK3; BK4), and in that the spatial position of the leads (A) is computed from the differing position of corresponding shadow edges of the leads (A) on the optoelectronic transducer (W2; W3; W4).

3. Process according to either of Claims 1 and 2, characterized in that a photodiode (FD) which is displaceable in two mutually perpendicular directions (Pf1, Pf2) is used as spatially resolving optoelectronic transducer (W1; W2; W3).

4. Process according to either of Claims 1 to 2, characterized in that a line of photodiodes which is displaceable perpendicular to the line direction is used as spatially resolving optoelectronic transducer (W4).

5. Process according to Claim 4, characterized in that a line of photodiodes is used, the individual photodiodes (FD) of which exhibit rectangular photosensitive surfaces which are elongated perpendicular to the line direction.

6. Process according to either of Claims 1 and 2, characterized in that a photodiode matrix is used as spatially resolving optoelectronic transducer (W1; W2; W3).

7. Process according to one of Claims 1 to 6, characterized in that at least one point light source is used for the illumination in two different directions.

8. Process according to Claim 7, characterized in that two point light sources which are disposed at a spacing from one another are used for the illumination in two different directions.

9. Process according to Claim 7 or 8, characterized by the use of a laser diode (LD1, LD2) as point light source.

10. Process according to Claim 2 and one of Claims 7 to 9, characterized in that at least one point light source fitted to the planting head (BK3; BK4) is used for the illumination in two different directions.

11. Process according to Claims 4 and 10, characterized in that the point light source is displaced synchronously with the line of photodiodes perpendicular to its line direction.

12. Process according to one of the preceding claims, characterized in that the respective component (B) is rotated relative to the spatially resolving optoelectronic transducer (W1; W2; W3; W4) in steps of 90° or 180° to encompass all lead regions.

13. Process according to Claim 2 and according to Claim 12, characterized in that the components (B) are rotated by means of the suction pipette (SP) of the planting head (BK1; BK2; BK3; BK4).

14. Planting head (BK4) for the automatic planting of printed circuit boards (LP) or ceramic substrates with components (B), having

- a suction pipette (SP) to take up, transport and position the components,
- a spatially resolving optoelectronic transducer (W4) and having
- at least one light source, in which
- the suction pipette (SP), and the spatially resolving optoelectronic transducer (W4) and the light source are arranged in such a manner that the light source generates successively in each case one direct shadow of the region of the leads at one component side of a component (B) taken up by the suction pipette (SP) by illumination from two different directions on the photosensitive surface of the spatially resolving optoelectronic transducer (W4) and the spatial position of the leads (A) is computed from the differing position of corresponding shadow edges of the leads (A) of the component (B) on the optoelectronic transducer (W4).

15. Planting head according to Claim 14, characterized in that the spatially resolving optoelectronic transducer (W4) is formed by a line of photodiodes which is displaceable perpendicular to its line direction.

16. Planting head according to Claim 15, characterized in that the individual photodiodes (FD) of the line of photodiodes exhibit rectangular photosensitive surfaces which are elongated perpendicular to the line direction.

17. Planting head according to one of Claims 14 to 16, characterized by a point light source.

18. Planting head according to Claim 17, characterized by two point light sources which are disposed at a spacing from one another.

19. Planting head according to Claim 18, characterized by two laser diodes (LD1, LD2) disposed at a spacing from one another.

20. Planting head according to Claims 15 and 18 or 19, characterized in that the point light sources are displaceable, by means of a common mounting (H), synchronously with the line of photodiodes perpendicular to its line direction.

**Revendications**

1. Procédé de reconnaissance de la position et/ou de vérification de l'écartement et/ou de vérification de la coplanarité des raccordements (A) de composants (B), dans lequel, par un éclairage provenant de deux directions différentes, on produit successivement à la surface photosensible d'un convertisseur (W2; W3; W4) optoélectronique à définition spatiale des projections directes d'ombre de la zone de raccordement d'une face de composant et, à partir de la différence de position de bords d'ombre correspondants des raccordements (A) sur le convertisseur (W2; W3; W4) optoélectronique, on calcule la position dans l'espace du raccordement (A).

2. Procédé de reconnaissance de la position et/ou de vérification de l'écartement et/ou de vérification de la coplanarité des raccordements (A) de composants (B), que, à l'aide d'une tête (BK2; BK3; BK4) d'insertion, on prélève d'une position de prélèvement prescrite d'un dispositif de mise à disposition de composants et qu'on met en position en une position prescrite sur une plaquette (LP) à circuits imprimés ou sur un substrat en céramique, caractérisé en ce que, par un éclairage provenant de deux directions différentes, on produit successivement à la surface photosensible d'un convertisseur (W2; W3; W4) optoélectronique à définition spatiale monté sur la tête (BK2;BK3;BK4) d'insertion des projections directes d'ombre de la zone de raccordement d'une face de composant et en ce que, à partir de la différence de position de bords d'ombre correspondants des raccordements (A) sur le convertisseur (W2; W3; W4) optoélectronique, on calcule la position dans l'espace du raccordement (A).

3. Procédé suivant l'une des revendications 1 ou 2, caractérisé en ce que l'on utilise comme convertisseur (W1; W2; W3) optoélectronique à définition spatiale une photodiode (FD) pouvant être déplacée dans deux directions (Pf1, Pf2) perpendiculaires l'une à l'autre.

4. Procédé suivant l'une des revendications 1 à 2, caractérisé en ce que l'on utilise comme convertisseur (W4) optoélectronique à définition spatiale une ligne de photodiode pouvant être déplacée perpendiculairement à la direction de la ligne.

5. Procédé suivant la revendication 4, caractérisé en ce que l'on utilise une ligne de photodiodes dont les photodiodes (FD) individuelles comportent des surfaces photosensibles rectangulaires, s'étendant en long perpendiculairement à la direction de la ligne.

6. Procédé suivant l'une des revendications 1 à 2, caractérisé en ce que l'on utilise comme convertisseur (W1; W2; W3) optoélectronique à définition spatiale une matrice de photodiodes.

7. Procédé suivant l'une des revendications 1 à 6, caractérisé en ce que l'on utilise, pour l'éclairage provenant de deux directions différentes, au moins une source lumineuse ponctuelle.

8. Procédé suivant la revendication 7, caractérisé en ce que l'on utilise, pour l'éclairage provenant de deux directions différentes, deux sources lumineuses ponctuelles disposées à distance l'une de l'autre.

9. Procédé suivant la revendication 7 ou 8, caractérisé en ce que l'on utilise une diode (LD1, LD2) laser comme source lumineuse ponctuelle.

10. Procédé suivant la revendication 2 et l'une des revendications 7 à 9, caractérisé en ce que l'on utilise, pour l'éclairage provenant de deux directions différentes, au moins une source lumineuse ponctuelle montée sur la tête (BK3; BK4) d'insertion.

11. Procédé suivant les revendications 4 et 10, caractérisé en ce que l'on déplace la source lumineuse ponctuelle en synchronisme avec la ligne de photodiodes, perpendiculairement à la direction de cette ligne.

12. Procédé suivant l'une des revendications précédentes, caractérisé en ce que, pour détecter toutes les zones de raccordement, on tourne le composant (B) associé par étapes de 90° ou de 180° par rapport au convertisseur (W1; W2; W3; W4) optoélectronique à définition spatiale.

13. Procédé suivant la revendication 2 et suivant la revendication 12, caractérisé en ce que l'on tourne les composants (B) à l'aide de la pipette (SP) d'aspiration de la tête (BK1; BK2; BK3; BK4) d'insertion.

14. Tête (BK4) d'insertion pour insérer automatiquement des composants (B) dans des plaquettes (LP) à circuits imprimés et dans des substrats en céramique, comportant

- une pipette (SP) d'aspiration pour recevoir, transporter et mettre en position les composants,
- un convertisseur (W4) optoélectronique à définition spatiale et
- au moins une source lumineuse
- la pipette (SP) d'aspiration, le convertisseur (W4) optoélectronique à définition spatiale et la source lumineuse étant disposés de telle manière que la source lumineuse, par un éclairage provenant de deux directions différentes, produit successivement à la surface photosensible du convertisseur (W4) optoélectronique à définition spatiale des projections directes d'ombre de la zone de raccordement d'une face d'un composant (B) reçu par la pipette (SP) d'aspiration et que, à partir de la différence de position de bords d'ombre correspondants des raccordements (A) du composant (B) sur le convertisseur (W4) optoélectronique, la position dans l'espace du raccordement (A) est calculée.

15. Tête d'insertion suivant la revendication 14, caractérisée en ce que le convertisseur (W4) optoélectronique à définition spatiale est formé par une ligne de photodiode pouvant être déplacée perpendiculairement à la direction de la ligne.

16. Tête d'insertion suivant la revendication 15, caractérisé en ce que les photodiodes (FD) individuelles de la ligne de photodiodes comportent des surfaces photosensibles rectangulaires, s'étendant en long perpendiculairement à la direction de la ligne.

17. Tête d'insertion suivant l'une des revendications 14 à 16, caractérisée par une source lumineuse ponctuelle.

18. Tête d'insertion suivant la revendication 17, caractérisée par deux sources lumineuses ponctuelles, disposées à distance l'une de l'autre.

19. Tête d'insertion suivant la revendication 18, caractérisée par deux diodes (LD1, LD2) laser disposées à distance l'une de l'autre.

20. Tête d'insertion suivant les revendications 15 et 18 ou 19, caractérisée en ce que les sources lumineuses ponctuelles peuvent, par l'intermédiaire d'une fixation (H) commune, être déplacées en synchronisme avec la ligne de photodiodes, perpendiculairement à la direction de la ligne.

FIG1

FIG2

**FIG 3**

**FIG 4**

# FIG5

# FIG6

## FIG 7

## FIG 8